# EUROPEAN PATENT APPLICATION

(11) **EP 0 768 708 A2**
(43) Date of publication of application: **16.04.1997**
(21) Application number: 96307510.6
(22) Date of filing: 16.10.1996
(51) Int. Cl.: H01L 21/60

(54) **Method for forming bumps on substrates for electronic components**

(30) Priority: 16.10.1995 US 543784
(71) Applicant: TEXAS INSTRUMENTS INCORPORATED, Dallas Texas 75265 (US)
(72) Inventor: Abbott, Donald C., Norton, Massachusetts 02766 (US); Frechette, Raymond A., Providence, Rhode Island 02904 (US); Marsh, Gary D., Medway, Massachusetts 02053 (US); Brook, Richard M., Austin, Texas 78759 (US)
(74) Representative: Legg, Cyrus James Grahame

(57) **Abstract**

A method and apparatus for forming bumps (73) on a substrate (13) is presented. The method includes locating a mask (12) over the substrate (13). The mask (12) has openings (15) to expose the substrate (13) at a locations (17) desired for forming the bumps (73). A plasma (57) is generated, and pellets or grains (69) a material for forming the bumps (73) is introduced into the plasma (57) to be transformed by the plasma (57) into liquid or molten droplets (64), which are thrown or deposited on the mask (12) and the exposed regions (17) of the substrate (13). The molten droplets (64) are allowed to coalesce on the substrate (13) to form the bumps (73). The mask is then removed. The mask can be of any appropriate material, which may be selected to enable recovery of any over sprayed bump material.

## Description

### BACKGROUND OF THE INVENTION

### FIELD OF THE INVENTION

This invention relates to improvements in electronic component manufacturing processes, and more particularly to improvements in methods for forming bumps on substrates, such as lead frames, circuit boards, semiconductor chips, glass substrates, or the like.

### RELEVANT BACKGROUND

In the manufacture of many types of devices, it is often desirable to form relatively thick bumps or protuberances at predetermined locations on a substrate, usually to provide structures to which electrical connections can be made. For example, in the construction of semiconductor devices, often microminiature integrated circuits are formed on a chip or wafer of semiconductor material. In order to enable electrical contacts to be made to various regions on the chip, and more specifically, to various components of integrated circuit constructed in the chip, bumps often are formed to which wires or other larger sized structures can be connected.

Thus, to manufacture certain types of semiconductor devices, it is necessary or advantageous to have thick spatially well defined and physically consistent bumps or thick deposits of different materials, such as silver or gold, deposited in specific areas of a substrate, such as a lead frame or a semiconductor silicon chip. In the past, this has been done by electroplating, sputter deposition, chemical vapor deposition, etching or other such chemical techniques. Recently bumps have been formed on a substrate by setting down a gold ball and physically deforming it with an anvil. Other techniques have been used, as well. These procedures are generally technically involved and may involve use of vacuum technology, aggressive chemicals, long cycle times, expensive capital equipment, many process steps, or sophisticated masking.

In technologies other than semiconductor fabrication, as well, the process of forming bumps to enable electrical contacts to be established may be used. In some applications, for example, in the manufacture of solar cells, or the like, structures may be formed on glass substrates to which electrical contact is needed. Many other applications also exist in which the formation of bumps on a substrate exist.

Thus, what is needed is a method and apparatus for rapidly, repeatable, and uniformly forming thick layers on substrates.

### SUMMARY OF THE INVENTION

In light of the above, it is, therefore, an object of the invention to provide an improved method for forming bumps on a substrate.

It is another object of the invention to provide an improved method of the type described that can produce well defined and shaped bumps on a substrate.

It is yet another object of the invention to provide an improved method of the type described that enables bump location tolerances to be improved over existing technologies.

It is another object of the invention to provide an improved method of the type described in which a number of bumps can be deposited rapidly and with a high degree of uniformity.

It is another object of the invention to provide an improved method of the type described in which bumps of predetermined shape can be deposited.

It is another object of the invention to provide an improved method of the type described in which over sprayed bump forming material can be recovered.

It is another object of the invention to provide an improved method of the type described in which the thickness of deposited bumps can be precisely and repeatably controlled, metallurgical properties of the bump, such as ductility and elongation are more controllable than previous methods, and physical characteristics of deposited material can be made consistent bump to bump and within a bump.

It is another object of the invention to provide an improved method of the type described in which bumps can be deposited in a molten or liquid state, without also requiring that the substrate on which the bumps are formed be heated, thereby reducing risks of heat damage to other substrate structures.

It is another object of the invention to provide an improved method of the type described in which bump deposition can be performed at relatively rapid rates.

It is another object of the invention to provide an improved method of the type described in which the shapes of the deposited bumps can be reproducibly controlled by mask shapes.

It is another object of the invention to provide an improved method of the type described in which deposited bumps can be made of many varied plasma sprayable materials.

It is another object of the invention to provide an improved method of the type described in which the process can be applied to various types of substrates, such as tab lead frames, silicon chips, glass substrates, circuit boards, ball grid arrays, or the like.

It is another object of the invention to provide an improved method of the type described in which waste treatment costs can be minimized.

These and other objects, features and advantages of the invention will be apparent to those skilled in the art from the following detailed description of the invention, when read in conjunction with the accompanying drawings.

According to a broad aspect of the invention, a method for forming a bump on a substrate is presented. The method includes locating over the substrate a mask having one or more openings to expose the substrate at a location desired for forming the bump. A plasma is generated, and a material for forming the bump is introduced into the plasma. The substrate is exposed to the plasma through the openings in the mask, and the powder in the plasma is allowed to coalesce in the opening to form the bump. The mask is then removed.

According to another broad aspect of the invention, a method for depositing bumps on a substrate, which may be a semiconductor, glass, lead frame, printed circuit board, or other suitable material, is presented. The method includes aligning a mask with respect to the substrate to bring apertures in the mask into alignment with exposed regions of the substrate on which bumps are to be formed. The mask is attached or affixed by a jig or other means to the substrate to form a target fixture, and a plasma of a gas is directed toward the target fixture. A substance is introduced into the plasma, which transforms the substance into a material to be deposited. The substance may be, for example, particles of a conductor in a solid phase, and the transformed material may be the conductor in a liquid phase. In one embodiment, the substance is substantially the same substance in a different phase after being transformed by the plasma, and in another embodiment, the substance at least partially combines with the gas of the plasma to form a different material for deposit.

The substance may be, for example, a conductor, selected, for instance from the group comprising silver, copper, gold, aluminum, zinc, platinum, palladium, and solder, such as tin-lead solder. Alternatively, the substance can be a semiconductor, or virtually any other material that can be transformed by the plasma into a desired bump forming material.

The target fixture and the plasma are then moved relative to each other so that the material is sprayed over the mask and onto the exposed regions of the substrate. The conductor in a liquid phase then coalesces or becomes restored to a solid phase after it has been deposited on the mask and the exposed regions of the substrate. Finally, the mask is removed from the substrate to leave the restored material remaining to form the desired bumps.

In one embodiment, the material sprayed onto the mask is controlled to a deposit thickness less than a thickness of the mask. One way by which the thickness of the material sprayed can be controlled is by controlling a feed rate of introduction of the substance into the plasma. Another way is to move the target fixture and the plasma relative to each other by controlling a rate of relative rotational or linear movement between the target fixture and the plasma.

Once the mask has been removed, the over spray material can be recovered by removing the deposited material from the mask in one embodiment, allowing the mask to be reused. The mask may be coated with a non-stick substance, if desired, to facilitate the over spray removal. In another embodiment, the mask may be dissolved to recover the remaining over spray material.

One of the advantages of the method of the invention is that by providing shaped apertures in the mask, bumps having similar predetermined desired sidewall shapes can be formed.

According to another broad aspect of the invention, an apparatus for depositing bumps on a substrate is presented. The apparatus includes a mask that is of thickness at least as large as the height of the bumps to be formed on the substrate, and that is removably positionable adjacent the substrate to form a target fixture with the substrate. The mask, which may be, for example, about 44 mils thick, has apertures positioned to expose regions of the substrate at which bumps are to be formed when the mask is placed in registration with the substrate. The mask may be of any appropriate material for the particular process being performed, for example, paper, which can be dissolved to recover any over sprayed material, metal with a non-stick coating, which allows the over sprayed material to be removed, or other suitable material.

A plasma generator generates a plasma of a gas at a temperature, for example, of about 7000 K., and directs the plasma along a deposition path. An apparatus, such as a jig or the like, is provided for positioning the mask and substrate in the deposition path, and an apparatus is provided for introducing a substance into the plasma. The substance may be a powder or pellets of a material having a grain size of between about 5 and 100 microns. The substance is transformed by the plasma into a deposition material, which is carried by the plasma along the deposition path to impact and deposit upon the mask and the exposed regions of the substrate. The deposition material may be the substance in molten or liquid form, for instance, if the gas that of which the plasma is generated is inert, such as argon, and does not combine with the substance. On the other hand, the deposition material may be a transformed form of the substance if the gas is one that may combine with the substance. The substance may, for example, be an electrical conductor, for instance, selected from the group comprising silver, copper, gold, aluminum, zinc, platinum, palladium, and solder, such as an appropriate tin-lead solder.

In order to produce uniform deposition of the material onto the mask and substrate, an apparatus may be provided for producing relative movement between the fixture and the deposition path. For example, one such apparatus may be an apparatus for rotating the fixture. Another such apparatus may also produce linear movement between the fixture and the deposition path, alone, or in combination with the rotation producing apparatus.

### BRIEF DESCRIPTION OF THE DRAWINGS

The present invention will now be further described, by way of example, with reference to the accompanying drawings, in which:
FIGURE 1 is an exploded perspective view of a mask aligned with a substrate to be held by a jig as a target fixture, the mask having apertures to define and expose the regions of the substrate at which bumps are to be formed, in accordance with a preferred embodiment of the invention;
FIGURE 2 is a perspective view of the substrate of FIGURE 1 after bumps have been formed, and after the mask has been removed, in accordance with a preferred embodiment of the invention;
FIGURE 3 is a side elevational view, schematically showing the relationship of a mask and substrate fixture formed of the components of FIGURE 1, together with a plasma gun and substance injector, in accordance with a preferred embodiment of the invention; and
FIGURE 4 is a side elevational cross-sectional view of the mask and substrate, showing bump forming material deposited thereon, illustrating the depth of material formed in mask apertures on the substrate, in accordance with a preferred embodiment of the invention.

### DETAILED DESCRIPTION OF THE PREFERRED EMBODIMENTS

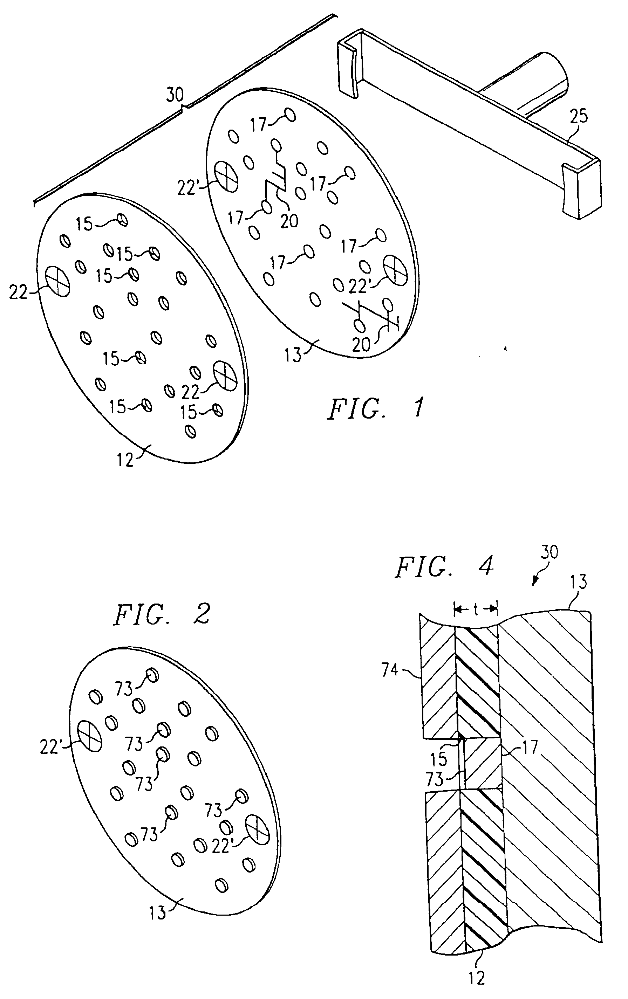

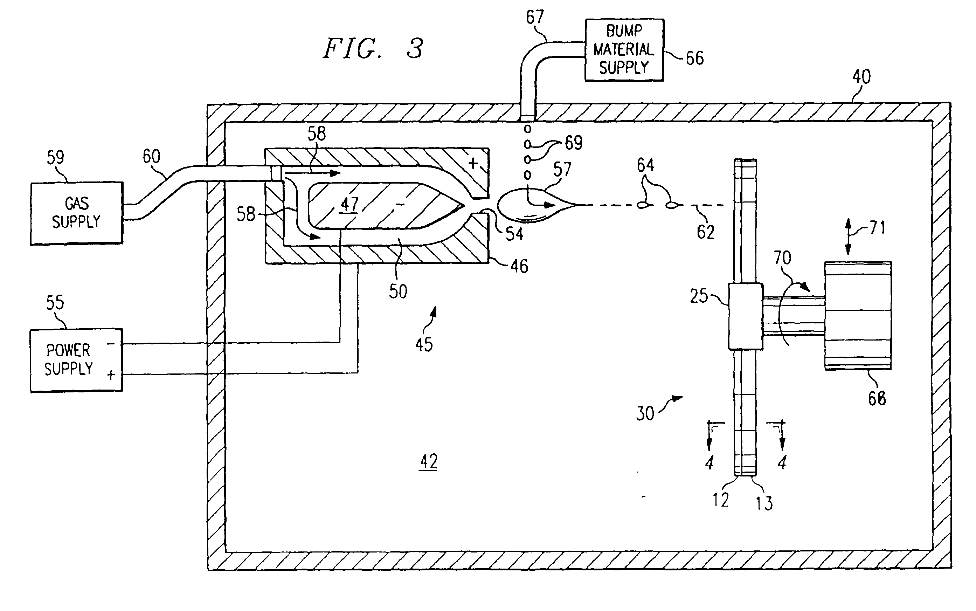

With reference first to Figure 1, an exploded perspective view of a mask 12 aligned with a substrate 13 is shown. A plurality of bumps are to be formed on the substrate 13; accordingly, the mask 12 has a plurality of apertures 15 to expose the regions 17 of the substrate 13 at which bumps are to be formed when the mask 12 is placed adjacent the substrate 13. The particular aperture pattern shown in Figure 1 has been arbitrarily chosen; however, it will be appreciated that any suitable aperture pattern can be employed.

As will become apparent, and as discussed below, the mask 12 may be of any appropriate material, depending upon the particular application in which the system is employed. For example, in some applications, the mask 12 may be paper or cardboard, in other applications, metal, plastic, or other appropriate material can be used.

The substrate 13 also may be of any appropriate material or form, such as semiconductor chips or wafers, glass substrates, tab lead frames, printed circuit boards, or other desired material. As will become apparent, the invention is particularly advantageously employed in conjunction with the formation of bumps on a semiconductor substrate that contains other semiconductor features 20, since there is no need in most cases for elevating the temperature of the substrate 13 on which the bumps are to be formed. Thus, the risk of damage to any features, integrated circuits, or other structures that may have been formed on the substrate 13 in previous processes or steps is reduced.

To assist in registering the desired position of the mask on the substrate, a number of alignment or registration marks 22 and 22' may be formed respectively on the mask 12 and substrate 13, as shown. Once the mask 12 and substrate 13 are properly registered, they may be secured in a jig 25 or similar device to maintain their relative positional relationship to assure that the bumps that will be subsequently formed are properly located on the substrate 13. (It should be noted that in place of the registration marks 22 and 22', the jig 25 may have its own locating or indexing pins or features, not shown, to be received in corresponding holes, not shown, on the mask to facilitate the proper alignment of the mask and the substrate.) The registered mask 12 and substrate 13 in the jig 25 form a target fixture 30 onto which material from which the bumps will be formed is thrown or applied, as next described.

The fixture 30 is then placed into a plasma reactor 40, which is shown schematically in a side cross-sectional view of Figure 3. The reactor 40 has a chamber 42 that contains a plasma gun 45, located opposite the target fixture 30. In the embodiment shown, the plasma gun 45 has an anode 46 surrounding a cathode 47 with an annular chamber 50 defined therebetween. The annular chamber 50 has an opening 54 oriented toward the target 30. Voltages for the anode 46 and cathode 47 are supplied by a power supply 55 of sufficient voltage to produce a plasma 57 of the gas that is introduced into the plasma gun 45, as next described.

The gas 58 from a gas supply 59 is introduced through a tube 60 into the annular chamber 50 between the anode 46 and cathode 47 of the plasma gun 45. The gas 58 is conducted through the chamber 50 and exits under pressure from the opening 54 in the direction of the target fixture 30 along a deposition path 62. As described above, the gas 58 is excited by the electric field between the anode 46 and cathode 47 to produce the plasma 57 from the opening 54. The gas 58 may be any appropriate gas that will produce a plasma and will interact with the substance to be transformed by the plasma 57 into a material for deposition onto the substrate to form the desired bumps. For example, if the gas is desired to be inert with respect to the substance for bump formation, argon or similar gas may be used. On the other hand, if the gas is to react with the substance, for example, to form a semiconductor compound, silane, hydrogen, or other similar gas may be used. The temperature of the gas plasma 57 may be, for instance, about 7000 K.

Powders, pellets, or grains of the substance material from a bump material supply 66 to be deposited are introduced into the chamber 42 through a tube 67. In the embodiment illustrated, the substance that is introduced are pellets or grains 69 in a solid phase, which are transformed by the plasma 57 to droplets 64 in a molten or liquid phase. However, as noted above, although the bumps are deposited in a molten or liquid state, the substrate onto which the bumps are formed need not be heated. Thus, the risks of heat damage to other substrate structures is not significantly increased through the use of the process of the invention.

It will be appreciated that the feed rate or rate of introduction of the bump material into the plasma 57 is directly proportional to the thickness of the deposited material onto the mask 12 and exposed regions 17 of the substrate 13. Thus, together with the other factors discussed herein, the rate of introduction of the bump material from the supply 66 can be adjusted to control the thickness of the bumps that are formed or deposited.

The particular material of the substance supplied into the plasma 57 is dependent upon the final bump material desired. The material may be, for example, a conductor, such as a conductor selected from the group consisting essentially of silver, copper, gold, aluminum, zinc, platinum, palladium, and solder, such as an appropriate tin-lead solder. Alternatively, the material may be a material that will combine with the gas of the plasma to form a semiconductor or other desired bump material.

The material to be deposited will be carried by the pressure of the gas and plasma leaving the opening 54 of the plasma gun 45; consequently, the relative pressures of the gas delivered via tube 43 and the particles delivered by the tube 47 should be such that the direction of the free particles within the chamber 42 will be controlled by the direction of the plasma 57. More particularly, it will be appreciated that as soon as the particles delivered through the tube 67 are injected into the plasma 57, they melt, forming droplets 64 of molten material, which are hurled by the pressure of the gas exiting the opening 54 of the plasma gun 45 onto the target fixture 30. Consequently, the gas should be introduced under sufficient pressure to propel the transformed material along the deposition path 62 to impact the target fixture 30. As the velocity of the propelled material against the target 30 may be one factor in controlling the thickness of the bumps that are deposited, the gas pressure can be adjusted as needed to vary or modify the bump thickness. Since a number of other factors also affect the bump deposition thickness, some experimentation may be necessary to derive the optimum desired gas pressure for particular bump materials, in conjunction with the other factors, described below.

To facilitate a uniform coating of the bump material over the mask 12 and exposed regions 17 of the substrate 13, the target fixture 30 may be moved relative to the deposition path 62. To provide such relative movement, a motor or similar apparatus 68 may be provided to rotate the jig 25 along a rotational path 70, whereby the droplets 64 can be sprayed uniformly around the target fixture 30. Additionally, the apparatus 68 can provide linear movement along path 71, so that the droplets coat the mask 12 and exposed regions 17 of the substrate 13 in a radial direction of the fixture 30. It can be seen that in addition to providing the ability to form a uniform material coating on the exposed portions of the substrate 13, the invention also enables the bump deposition to be relatively rapidly performed.

It will be appreciated that the thickness of the deposited material will vary inversely with the relative velocity between the fixture 30 and the deposition path. Thus, together with the other factors discussed herein, the relative velocity can be adjusted to control the thickness of the bumps deposited. Other factors that may affect the thickness of the material deposited, and ultimately the thickness of the bumps formed on the substrate 13, include the physical characteristics of the material that is deposited, such as the surface tension of the material, which is a function of the material itself, and which may be affected by the temperature of the material as it impacts the target fixture 30. This may, in turn, be affected by the temperature of the target fixture 30 and by the ambient temperature within the chamber 42, which may affect the rate at which the bump material coalesces on exposed regions of the substrate. Thus, it will be apparent that some experimentation may be necessary to control the precise bump thickness; however, once the parameters for a particular process are established, the process can be repeated with consistently uniform results.

After the material from which the bumps are formed has been deposited on the mask 12 and exposed regions 17 of the substrate 13, the mask 12 and substrate 13 may be removed from the jig 25, and the mask 12 separated from the substrate 13. This will leave the bumps 73 on the substrate 13, as shown in Figure 2, in the desired pattern. Moreover, by shaping the apertures 15 in the mask 12, the resulting sidewall cross-sectional shape of the resulting bumps 73 can be made to any desired pattern. In the embodiment shown, for example, the bumps 73 have a circular cross-sectional shape, resulting in cylindrically shaped bumps. Other bump shapes, such as cubic, elliptical, or other shape, can easily be achieved by appropriate modification of the mask apertures.

In order to facilitate the removal of the mask 12 from the substrate 13, it is apparent that preferably the deposited bump material be discontinuous at the mask surface and the exposed substrate regions. Thus, as shown in Figure 4, the thickness, t, of the mask 12 is preferably at least as thick as the thickness of the deposited material 74, and therefore of the height, of the bumps 73. In other words, the thickness of the material 74 that is deposited should be controlled as herein described to be equal to or less than the thickness, t, of the mask 12. Although in some applications in which the integrity of the bumps may not be an important factor, or in which the deposited material may be easily broken or separated, the mask thickness may be less than the desired bump thickness, by providing a mask thickness greater than the final bump thickness, the quality of the bumps remaining after the mask has been removed can be assured.

Since the method described results in over spray of the bump material onto the surface of the mask 12, it may be desirable to recover the over sprayed material, depending upon the deposited material. For example if the bump material is a precious metal such as gold or platinum, such over spray recovery would be highly desirable. This consideration can be addressed in the selection of the material of which mask is constituted. For example, if the mask were to be of paper or cardboard, if the particular application would permit such selection, after use the paper or cardboard might be dissolved to recover the over sprayed bump material. Other materials also may be dissolved by solvents that selectively attack the particular mask material, but not the over sprayed bump material.

On the other hand, in some applications, the bump material may be of such character that it can easily be physically peeled or mechanically removed from the mask. If desired, a non-stick coating may be applied to the mask to facilitate such mechanical removal of the over sprayed bump material. As a result of the ability to recover the over sprayed material, it can be seen that waste treatment costs can be minimized.

Thus, it can be seen that a novel method and apparatus have been presented for forming bumps of various shapes and materials onto a substrate, without involving high vacuum, aggressive chemicals, or long cycle times. At the same time, the method produces uniform and repeatable results.

Although the invention has been described and illustrated with a certain degree of particularity, it is understood that the present disclosure has been made only by way of example, and that numerous changes in the combination and arrangement of parts can be resorted to by those skilled in the art without departing from the spirit and scope of the invention.

## Claims

1. A method of forming bumps on a substrate comprising;
locating a mask in a region substantially overlying the substrate, said mask having one or more openings to expose regions on said substrate at which bumps are desired to be formed;
generating a gas plasma and directing the plasma towards the mask;
introducing a substance into the plasma, the substance being transformed by the plasma into a material for forming the bumps;
depositing the material onto the mask and the exposed regions of the substrate, and allowing the material to coalesce on the exposed regions of the substrate to form the bumps; and
removing the mask.

2. The method as claimed in Claim 1 further comprising; providing a mask having a pattern of openings.

3. The method as claimed in Claim 1 or Claim 2, wherein the step of introducing the substance into the plasma comprises transforming said substance into a material in a liquid state.

4. The method as claimed in any preceding claim further comprising the step of;
aligning the mask with respect to the substrate to align openings in the mask to exposed regions of the substrate on which bumps are to be formed.

5. The method as claimed in any preceding claim further comprising the step of;
fixing the mask to the substrate to form a target fixture, and directing the plasma towards the target fixture.

6. The method as claimed in Claim 5 further comprising the step of;
moving the target fixture or the plasma relative to each other such that material is deposited over a region of the mask and onto exposed regions of the substrate.

7. The method as claimed in any preceding claim, wherein the step of removing the mask comprises removing the mask from the substrate to leave deposited material on exposed regions of the substrate to form the bumps.

8. The method as claimed in any preceding claim, wherein the step of introducing a substance into the plasma comprises introducing a substance comprising particles of a conductor in a solid phase, which particles of the conductor are transformed into the liquid phase but which are restored to the solid phase after being deposited on the mask and exposed regions of the substrate.

9. The method as claimed in any preceding claim, wherein the step of depositing the material further comprises controlling the material deposited onto the mask and exposed regions of the substrate to deposit a thickness of material in exposed regions of the substrate which is less than the thickness of the mask.

10. The method as claimed in any preceding claim, wherein the step of introducing the substance further comprises controlling a feed rate of said substance into the plasma to control the thickness of material that is deposited onto the mask and exposed regions of the substrate.

11. The method as claimed in any of Claims 6 to 10, wherein the step of moving the target fixture and the plasma relative to one another is performed by controlling the rate of relative rotational movement between the target fixture and the plasma.

12. The method as claimed in any of Claims 6 to 11, wherein the step of moving the target fixture and the plasma relative to one another comprises moving the plasma along a linear path.

13. The method as claimed in any preceding claim further comprising; removing said deposited material from said mask after said mask has been removed from said substrate, and reusing said mask.

14. The method as claimed in any preceding claim further comprising; recovering said deposited material from said mask after said mask has been removed from said substrate.

15. The method as claimed in Claim 14, wherein said step of recovering said deposited material comprises dissolving said mask.

16. The method as claimed in any preceding claim further comprising; providing shaped openings in said mask, said shaped openings forming a desired sidewall shape to said bumps.

17. The method as claimed in any of Claims 5 to 16, wherein said step of fixing said mask on said substrate to form a target fixture comprises mounting said mask and said substrate in a jig.

18. The method as claimed in any preceding claim, wherein the step of introducing the substance comprises introducing a substance which is substantially the same substance in a different phase after being transformed by said plasma.

19. The method as claimed in any preceding claim, wherein the step of introducing the substance comprises introducing a substance which at least partially combines with the gas of said plasma.

20. The method as claimed in any preceding claim, wherein the step of introducing the substance comprises introducing a substance which is a conductor.

21. The method as in any preceding claim, wherein the step of introducing the substance comprises introducing a substance which is a powder.

22. The method as claimed in any preceding claim, wherein the step of introducing the substance comprises introducing a conductor which is selected from the group of materials consisting of; silver, copper, gold, aluminum, zinc, platinum, palladium, solder, or alloys thereof.

23. The method as claimed in any preceding claim, wherein the step of introducing the substance comprises introducing a substance which is a semiconductor.

24. The method as claimed in any preceding claim, wherein said step of introducing a substance into said plasma is stopped before a continuous layer of deposited material is formed between said mask and said exposed regions of said substrate.

25. Apparatus for depositing bumps on a substrate, comprising:
a mask having a thickness at least as large as a height of said bumps to be formed on said substrate and being removably positionable adjacent said substrate to form a fixture with said substrate, said mask having openings positioned to expose regions of said substrate at which bumps are to be formed when said mask is placed in registration with said substrate;
means for providing a gas
means for generating a plasma of said gas and directing said plasma along a deposition path;
means for positioning said mask and substrate in said deposition path; and
means for introducing a substance into said plasma, said substance being transformed by said plasma into deposition material and carried by said plasma along said deposition path to be deposited upon said mask and exposed regions of said substrate.

26. The apparatus as claimed in Claim 25, wherein said mask is about 44 mils thick.

27. The apparatus as claimed in Claim 25 or Claim 26, wherein said mask is paper.

28. The apparatus as claimed in any of Claims 25 to 27, further comprising; a non-stick coat on said mask to enable material deposited on said mask to be removed.

29. The apparatus as claimed in any of Claims 25 to 28, wherein said gas comprises argon.

30. The apparatus as claimed in any of Claims 25 to 29, wherein said plasma has a temperature of about 7000 K.

31. The apparatus as claimed in any of Claims 25 to 30, wherein said substance is a conductor.

32. The apparatus as claimed in Claim 31, wherein said conductor comprises gold.

33. The apparatus as claimed in Claim 31, wherein said conductor is selected from the group consisting of; silver, copper, gold, aluminum, zinc, platinum, palladium, solder, and alloys thereof.

34. The apparatus as claimed in any of Claims 25 to 33, further comprising; apparatus for producing relative movement between said fixture and said deposition path.

35. The apparatus as claimed in Claim 34, wherein said apparatus for producing relative movement comprises apparatus for rotating said fixture.

36. The apparatus as claimed in Claim 34 or Claim 35, wherein said apparatus for producing relative movement further comprises apparatus for producing linear movement between said fixture and said deposition path.

37. The apparatus as claimed in any of Claims 34 to 36, wherein said apparatus for producing relative movement further comprises apparatus for producing linear movement between said fixture and said deposition path.

38. The apparatus as claimed in any of Claims 25 to 37, wherein said substance comprises pellets in a solid state of a material to be deposited.

39. The apparatus as claimed in Claim 38, wherein said plasma transforms said pellets to a molten state and propels said molten state pellets along said deposition path.

40. The apparatus as claimed in Claim 38 or Claim 39, wherein said pellets have a grain size of between about 5 and 100 microns.

41. The apparatus as claimed in any of Claims 25 to 40, wherein said deposition material is discontinuous between said mask deposit and said deposit in said exposed regions of said substrate.
